# EUROPEAN PATENT SPECIFICATION

(11) **EP 0 800 268 B1**
(45) Date of publication and mention of the grant of the patent: **08.10.2003**
(21) Application number: 97105293.1
(22) Date of filing: 27.03.1997
(51) Int. Cl.: H03H 9/17, H03H 9/58

(54) **Piezoelectric resonator**
Piezoelektrischer Resonator
Résonateur piézoélectrique

(30) Priority: 05.04.1996 JP 11047596; 18.04.1996 JP 12272596; 16.01.1997 JP 2010297
(43) Date of publication of application: 08.10.1997
(73) Proprietor: MURATA MANUFACTURING CO., LTD., Nagaokakyo-shi Kyoto-fu 226 (JP)
(72) Inventor: Unami, Toshihiko, Nagaokakyo-shi, Kyoto-fu (JP); Inoue, Jiro, Nagaokakyo-shi, Kyoto-fu (JP)
(74) Representative: Gossel, Hans K., Dipl.-Ing.

(56) References cited:
- GB-A- 2 087 184
- US-A- 3 378 704
- US-A- 4 939 403
- HIDEKI TOMINAGA ET AL: "DEVICES USING HIGH-COUPLING PIEZOELECTRIC CRYSTALS" FUJITSU-SCIENTIFIC AND TECHNICAL JOURNAL, vol. 24, no. 2, 21 June 1988, pages 71-99, XP000048152

## Description

### BACKGROUND OF THE INVENTION

The present invention relates to a piezoelectric resonator which uses the mechanical resonance of a piezoelectric member, and more particularly, to a piezoelectric resonator comprising a base member having a longitudinal direction, an active section composed of polarized piezoelectric member and constituting at least a part of the base member, and a pair of external electrodes provided with the active section.

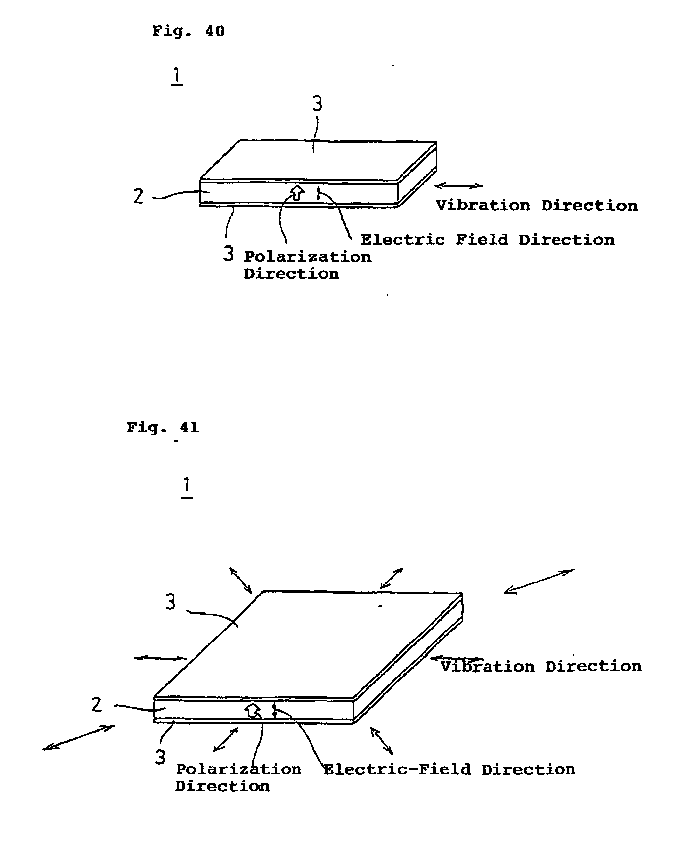

Fig. 40 is a perspective view of a conventional piezoelectric resonator. A piezoelectric resonator 1 includes a piezoelectric substrate 2 having, for example, a rectangular plate shape viewed from the top. The piezoelectric substrate 2 is polarized in the thickness direction. On both surfaces of the piezoelectric substrate 2, electrodes 3 are formed. When a signal is input between the electrodes 3, an electrical field is applied to the piezoelectric substrate 2 in the thickness direction and the piezoelectric substrate 2 vibrates in the longitudinal direction. In Fig. 41, there is shown a piezoelectric resonator 1 in which electrodes 3 are formed on both surfaces of a piezoelectric substrate 2 having a square plate shape viewed from the top. The piezoelectric substrate 2 of the piezoelectric resonator 1 is polarized in the thickness direction. When a signal is input between the electrodes 3 in the piezoelectric resonator 1, an electrical field is applied to the piezoelectric substrate 2 in the thickness direction and the piezoelectric substrate 2 vibrates in square-type vibration mode (in the plane direction).
Since when viewed from the top the piezoelectric substrate of the piezoelectric resonator shown in Fig. 40 has a rectangular plate shape, the substrate cannot be made much thinner due to restrictions in strength. Therefore, the distance between the electrodes cannot be reduced and a capacitance between terminals cannot be made large. This is extremely inconvenient for achieving impedance matching with an external circuit. To form a ladder filter by connecting a plurality of piezoelectric resonators in series and in parallel alternately, the capacitance ratio of the series resonator to the parallel resonator needs to be made large in order to increase attenuation. Because a piezoelectric resonator has shape restriction described above, however, large attenuation cannot be obtained.
Such a piezoelectric resonator uses the first-order resonance in the longitudinal mode. It also generates due to its structure large spurious resonances in odd-number-order harmonic modes, such as the third-order and fifth-order modes, and in width mode. To suppress these spurious resonances, some measures are considered, such as polishing, increasing mass, and changing the shape of the electrode. These measures increase manufacturing cost.
In the piezoelectric resonator shown in Fig. 41, large spurious resonances such as those in the thickness mode and in the triple-wave mode in the plane direction are generated. Since the piezoelectric resonator needs a large size as compared with a piezoelectric resonator using the longitudinal vibration in order to obtain the same resonant frequency, it is difficult to reduce the piezoelectric resonator in size. When a ladder filter is formed by a plurality of piezoelectric resonators, in order to increase the capacitance ratio between the series resonator and the parallel resonator, the resonators connected in series are made thick and electrodes are formed only on part of a piezoelectric substrate to make the capacitance small as well. In this case, since the electrodes are only partially made, the difference ΔF between the resonant frequency and the antiresonant frequency as well as the capacitance is reduced.
The resonators connected in parallel are accordingly required to have small ΔF. As a result, the piezoelectricity of the piezoelectric substrate is not effectively used, and the transmission band width of the filter cannot be increased.
These piezoelectric resonators are of an unstiffened type, in which the vibration direction differs from the direction of polarization and the electrical field. The electromechanical coupling coefficient of such an unstiffened piezoelectric resonator is lower than that of a stiffened piezoelectric resonator, in which the vibration direction, the direction of polarization, and the direction in which an electrical field is applied are the same. An unstiffened piezoelectric resonator has a relatively small frequency difference ΔF between the resonant frequency and the antiresonant frequency. This leads to a drawback in which a frequency-band width in use is narrow when an unstiffened frequency resonator is used as an oscillator or a filter.
Therefore, the degree of freedom in characteristics design is low in such a piezoelectric resonator and electronic components using the same.

A piezoelectric resonator having the features of the preamble of claim 1 is known from US-A-4,939,403 and US-A-3,378,704.

### SUMMARY OF THE INVENTION

Accordingly, it is the main object of the present invention to provide a piezoelectric resonator having a small spurious resonance, a large difference ΔF between the resonant frequency and the antiresonant frequency, adjustable capacitance and ΔF, and a large degree of freedom in characteristics design.

This object is achieved with a piezoelectric resonator having the features of claim 1. The subclaims are directed to preferable embodiments.

In the above described piezoelectric resonator, said plurality of piezoelectric layers may be polarized in opposite directions at both sides of said plurality of internal electrodes in the longitudinal direction of said base member, and adjacent internal electrodes among said plurality of internal electrodes may be connected to said one pair of external electrodes, respectively.
In the above described piezoelectric resonator, said plurality of internal electrodes may be partially exposed at side faces of said base member, and the exposed portions of adjacent internal electrodes among said plurality of internal electrodes may be connected to said pair of external electrodes, respectively.
In the above described piezoelectric resonator, an inactive section, in which no electric field is applied or which is not polarized, may be provided in the other part of said base member.

It is preferred that said inactive section is provided at both ends of said active section, and said active section occupies 50% of said base member or more in the longitudinal direction.
The above described piezoelectric resonators may further comprise a support member, and a mounting member disposed between said support member and a center section of said base member in the longitudinal direction.
The forgoing object is achieved in another aspect of the present invention through the provision of an electric component for use with the above described resonators, which is characterized in that said support member is an insulating substrate on which a pattern electrode is provided, and said base member is mounted on said insulating substrate through said mounting member.
The above described electric component may be a ladder filter in which a plurality of said base member is mounted on said insulating substrate through said mounting member and connected to each other in a ladder shape.

Since a piezoelectric resonator according to the present invention has a base member in which piezoelectric layers and electrodes are alternately laminated, the capacitance of the piezoelectric resonator can be changed by adjusting the intervals, the sizes, or the number of electrodes used for applying an electric field to the base member. When such a piezoelectric resonator is formed such that the vibration direction, the direction of polarization, and the direction in which an electrical field is applied are the same in the piezoelectric layers, the resonator is of a stiffened type. Therefore, as compared with an unstiffened piezoelectric resonator, in which the vibration direction differs from the direction of polarization and electrical field, the stiffened piezoelectric resonator has a larger electromechanical coupling coefficient and a larger frequency difference ΔF between the resonant frequency and the antiresonant frequency. In addition, vibrations in modes such as the width and thickness modes, which are different from the basic vibration, are unlikely to occur in a stiffened piezoelectric resonator. Furthermore, the frequency difference ΔF and the resonant frequency can be adjusted by trimming an inactive section provided or by adding mass to the section.
When electronic components such as an oscillator, a discriminator, and a filter are made using the piezoelectric resonator, the piezoelectric resonator is mounted on an insulating substrate on which pattern electrodes are formed and is covered by a cap to form chip-type (surface mount) electronic components.
According to the present invention, since the capacitance of the piezoelectric resonator can be adjusted, it is easy to achieve impedance matching with an external circuit in a case when the piezoelectric resonator is mounted on a circuit board and used. When the piezoelectric resonator is of a stiffened type, the frequency difference ΔF between the resonant frequency and the antiresonant frequency is large as compared with a conventional piezoelectric resonator, and thus a wide-frequency-band resonator is obtained. In addition, vibrations in modes other than the basic-vibration mode are unlikely to occur in this piezoelectric resonator, and superior characteristics are achieved. Since the frequency difference ΔF is adjusted by adjusting the inactive section, the frequency-band width of the piezoelectric resonator can be changed.
Since a chip-type electronic component can be made using the piezoelectric resonator, it is easy to mount the component on a circuit board. It is also easy to achieve impedance matching between such an electronic component and an external circuit by adjusting the capacitance of the piezoelectric resonator. In addition, in a ladder filter formed by connecting a plurality of piezoelectric resonators in series and in parallel alternately, attenuation in the filter can be adjusted by changing the ratio of the capacitance of the piezoelectric resonator connected in series to that of the piezoelectric resonator connected in parallel.
The above-described object, other objects, other features, and other advantages of the present invention will be made clear in the following description noted by referring to the drawings.

### BRIEF DESCRIPTION OF THE DRAWINGS

- Fig. 1: is a perspective view of a piezoelectric resonator according to the present invention.
- Fig. 2: is a view showing the structure of the piezoelectric resonator shown in Fig. 1.
- Fig. 3: is a perspective view indicating how ceramic green sheets are laminated in order to produce the piezoelectric resonator shown in Fig. 1.
- Fig. 4: is a view showing a laminated block formed by the ceramic green sheets shown in Fig. 3.
- Fig. 5: is a view showing portions where the laminated block shown in Fig. 4 is cut.
- Fig. 6: is a view showing a plate-shaped block made by cutting the laminated block shown in Fig. 5.
- Fig. 7: is a view showing the condition in which a resin insulating material is applied to the plate-shaped block shown in Fig. 6 and external electrodes are formed.
- Fig. 8: is a perspective view of an unstiffened piezoelectric resonator which vibrates in the longitudinal direction, which is shown for comparison.
- Fig. 9: is a perspective view of a stiffened piezoelectric resonator which vibrates in the longitudinal direction.
- Fig. 10: is a perspective view of an unstiffened piezoelectric resonator which vibrates in the plane direction (square-type vibration), which is shown for comparison.
- Fig. 11: is a view showing another piezoelectric resonator according to the present invention.
- Fig. 12: is a view showing still another piezoelectric resonator according to the present invention.
- Fig. 13: is a chart showing the relationship between the frequency and the impedance of the piezoelectric resonator according to the present invention.
- Fig. 14: is a chart showing the relationship between the frequency and the impedance of a conventional piezoelectric resonator.
- Fig. 15: is a view of a piezoelectric resonator in which the distribution of an active section and inactive sections is changed in a base member.
- Fig. 16: is a chart indicating the relationship between the distribution of an active section and capacitance, and ΔF/Fa.
- Fig. 17: is a chart showing the relationship between an active-section ratio and ΔF.
- Fig. 18: is a view showing a modified piezoelectric resonator according to the present invention.
- Fig. 19: is a view showing another modified piezoelectric resonator according to the present invention.
- Fig. 20: is a view showing still another piezoelectric resonator according to the present invention.
- Fig. 21: is a view indicating the gap between the end of an internal electrode and a side face of a base member in the piezoelectric resonator.
- Fig. 22: is a chart indicating the relationships between the capacitance and ΔF, and the gap between an internal electrode and a side face of the base member.
- Fig. 23: is a plan showing modified piezoelectric layers of the piezoelectric resonator shown in Fig. 20.
- Fig. 24: is a view showing a piezoelectric resonator having the piezoelectric layers shown in Fig. 23.
- Fig. 25: is a view showing a modified inactive section of a piezoelectric resonator.
- Fig. 26: is a view showing another modified inactive section of a piezoelectric resonator.
- Fig. 27: is a view showing an electrode formed at an end of a base member.
- Fig. 28: is a perspective view of an electronic component using the above-described piezoelectric resonator.
- Fig. 29: is a perspective view of an insulating substrate used in the electronic component shown in Fig. 28.
- Fig. 30: is an exploded perspective view of the electronic component shown in Fig. 28.
- Fig. 31: is a view indicating another method for mounting the piezoelectric resonator to the insulating substrate.
- Fig. 32: is a side view showing the method for mounting the piezoelectric resonator, shown in Fig. 31.
- Fig. 33: is a view indicating still another method for mounting the piezoelectric resonator to the insulating substrate.
- Fig. 34: is a side view showing the method for mounting the piezoelectric resonator, shown in Fig. 33.
- Fig. 35: is an exploded perspective view of a ladder filter using the piezoelectric resonators according to the present invention.
- Fig. 36: is a perspective view of an insulating substrate and the piezoelectric resonators in the ladder filter shown in Fig. 35.
- Fig. 37: is an equivalent circuit diagram of the ladder filter shown in Fig. 35.
- Fig. 38: is an exploded perspective view of a two-terminal electronic component.
- Fig. 39: is a chart indicating the relationship between Cf and ΔF/Fa, and other parameters.
- Fig. 40: is a view of a conventional unstiffened piezoelectric resonator.
- Fig. 41: is a view of another conventional unstiffened piezoelectric resonator.

### DESCRIPTION OF THE PREFERRED EMBODIMENTS

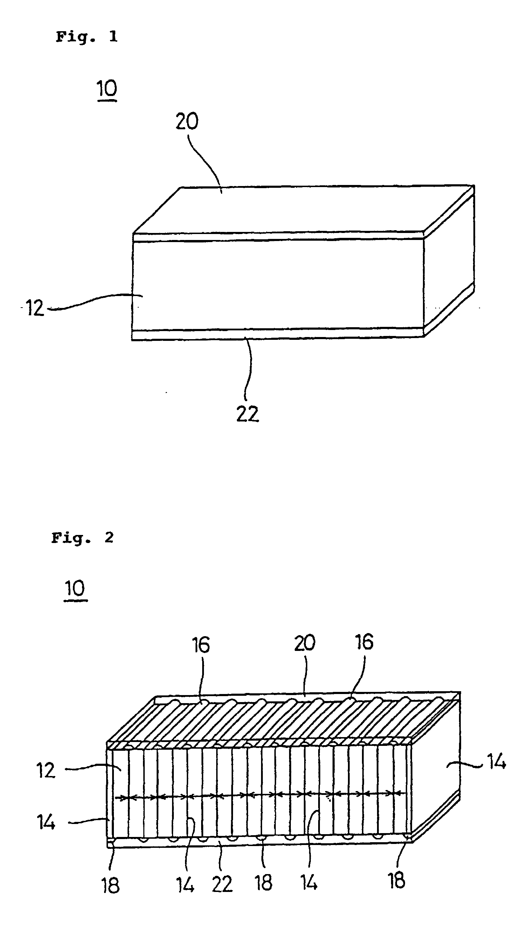

Fig. 1 is a perspective view of a piezoelectric resonator according to an embodiment of the present invention. Fig. 2 shows the internal structure of the piezoelectric resonator. The piezoelectric resonator 10 includes a base member 12 having, for example, a rectangular-parallelepiped shape. The base member 12 is made from, for example, a piezoelectric, ceramic material. A plurality of electrodes 14 is formed in the base member 12 and at both end faces of the base member 12 in the longitudinal direction such that the surfaces of the electrodes 14 are perpendicular to the longitudinal direction of the base member 12. The base member 12 is polarized in the longitudinal direction such that the directions of polarization oppose each other at both sides of one electrode 14.
On the opposing side faces of the base member 12, a plurality of insulating films 16 and 18 is formed, respectively. On one side face of the base member 12, the insulating film 16 covers the exposed section of every other electrode 14. On the other side face of the base member 12, the insulating film 18 covers the exposed section of every other electrode 14 not covered by the insulating film 16 on the above-described side face. The side faces of the base member 12 on which the insulating films 16 and 18 are formed serve as connection sections to external electrodes, which will be described later.
In these connection sections, namely, the side faces of the base member 12 on which the insulating films 16 and 18 are formed, external electrodes 20 and 22 are formed. The electrode 20 connects to electrodes 14 which are not covered by the insulating film 16, and the electrode 22 connects to electrodes 14 which are not covered by the insulating film 18. In other words, two adjacent electrodes 14 are connected to the electrodes 20 and 22, respectively. The piezoelectric resonator 10 uses the external electrodes 20 and 22 as input and output electrodes. The base member 12 is piezoelectrically active because an electric field is applied between adjacent electrodes 14.

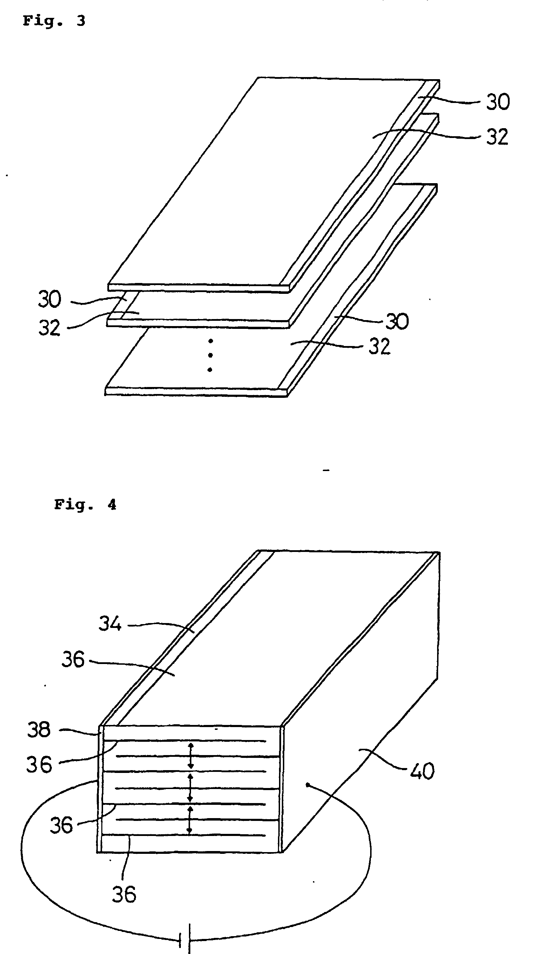

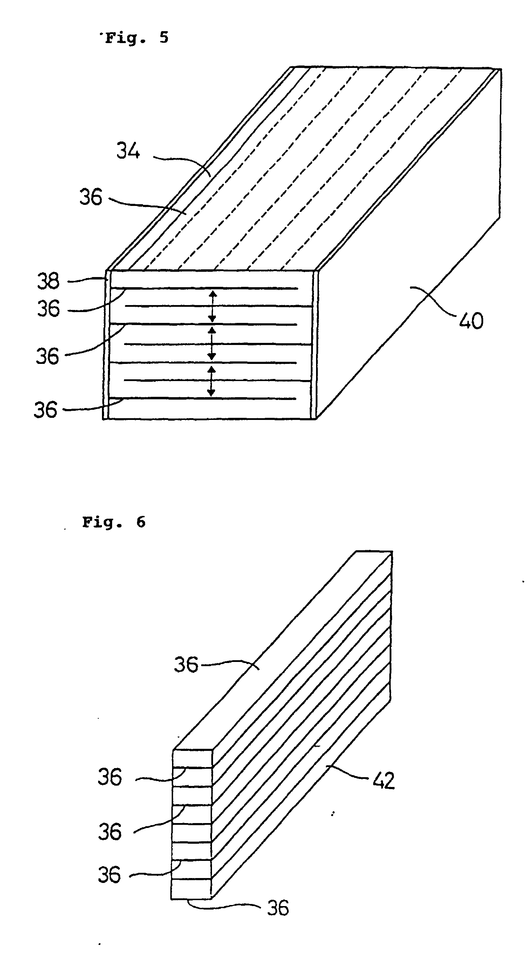

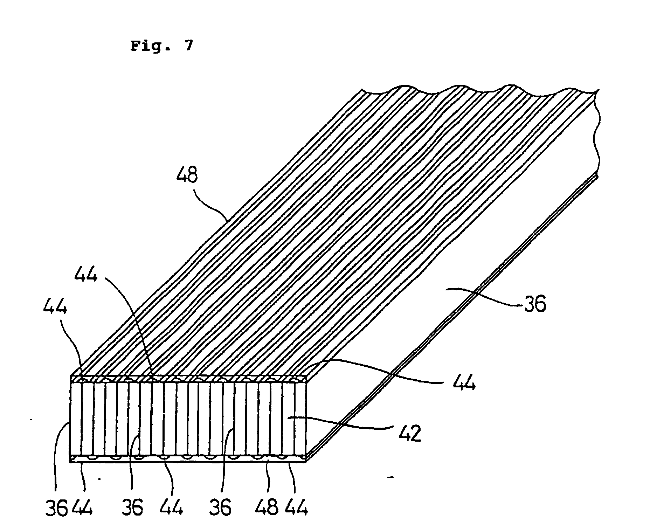

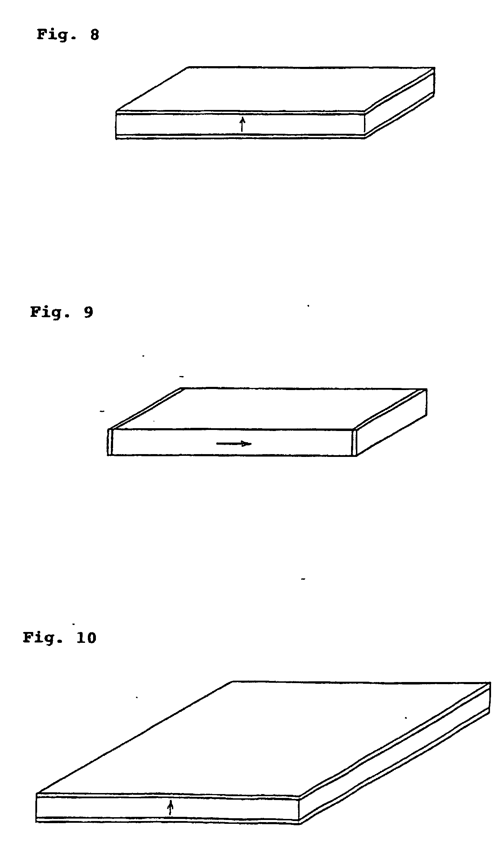

To make the piezoelectric resonator 10, green sheets 30 made from piezoelectric ceramic are first prepared as shown in Fig. 3. On one surface of each green sheet 30, electrically conductive paste including, for example, silver, palladium, and an organic binder, is applied to form an electrically conductive paste layer 32 over almost the entire area of each green sheet 30 excluding an end portion. A plurality of green sheets 30 is laminated such that the end portions where the electrically conductive paste layers 32 are not formed on the green sheets are placed alternately in opposite directions. The laminated member with electrically conductive paste applied to opposite side faces is baked to form a laminated block 34 shown in Fig. 4. A plurality of electrodes 36, which have been made by baking the electrically conductive layers 32, are formed in and at both ends of the laminated block 34. External electrodes 38 and 40 formed on opposite side faces are connected to every other electrode 36, respectively, since the electrodes 36 are alternately exposed on opposite side faces of the laminated block 34. When a DC voltage is applied to the external electrodes 38 and 40, the laminated block 34 is polarized. Inside the laminated block 34, a high DC electric field is applied between adjacent internal electrodes 36 alternately in opposite directions. Therefore, the laminated block 34 is polarized in the opposite directions at both sides of the electrodes 36 as shown by arrows in Fig. 4.
The laminated block 34 is surface-ground to the desired thickness since the antiresonant frequency of the resonator is determined by the thickness of the laminated block 34. The laminated block 34 is cut by a dicing machine along dotted lines shown in Fig. 5 such that the cutting planes are perpendicular to the plurality of electrodes 36. Then, a plate-shaped block 42 shown in Fig. 6 is obtained. A resin insulating material 44 is applied to both surfaces of the plate-shaped block 42 as shown in Fig. 7 such that the material 44 is applied to every other internal electrode 36 on one surface and every other electrode 36 to which the material 44 is not applied, on the other surface. External electrodes 48 are formed on the plate-shaped block 42. Then, the resultant block is cut perpendicularly to the internal electrodes 36 to form the piezoelectric resonator 10 shown in Fig. 1.
When a signal is applied to the external electrodes 20 and 22 in the piezoelectric resonator 10, since voltages are applied in opposite directions to the piezoelectric layers polarized in opposite directions in the base member 12, the piezoelectric layers expand and contract in the same direction as a whole. An AC electric field in the longitudinal direction of the base member 12 is applied to each piezoelectric layer by use of the electrodes 14 connected to the external electrodes 20 and 22, and a driving force for expansion and contraction is generated at each piezoelectric layer. Therefore, the piezoelectric resonator 10 vibrates in the longitudinal direction in basic mode with the center of the base member 12 serving as a node.
Since the piezoelectric resonator 10 has a structure in which a plurality of piezoelectric layers and electrodes are alternately laminated, the capacitance of the piezoelectric resonator 10 can be changed by adjusting the number of the laminated layers, the electrode size, or the distances between the electrodes. Therefore, it is easy to achieve impedance matching with an external circuit when the piezoelectric resonator 10 is mounted on a circuit board and used.
In the piezoelectric resonator 10 shown in Fig. 1, the polarization direction of the base member 12, the applied electric field direction due to a signal, and the direction of vibration in the base member 12 are all the same. In other words, the piezoelectric resonator 10 is of stiffened type. The stiffened piezoelectric resonator 10 has a larger electromechanical coupling coefficient than an unstiffened piezoelectric resonator, in which the direction of vibration differs from the direction of polarization and electric field. Therefore, the piezoelectric resonator 10 has a larger frequency difference ΔF between the resonant frequency and the antiresonant frequency than the conventional piezoelectric resonator. This means that the piezoelectric resonator 10 obtains wide-frequency-band characteristics.
To measure differences between stiffened and unstiffened piezoelectric resonators, piezoelectric resonators shown in Figs. 8, 9, and 10 were made. The piezoelectric resonator shown in Fig. 8 was made by forming electrodes on both surfaces in the thickness direction of a piezoelectric substrate measuring 4.0 mm by 1.0 mm by 0.38 mm. This piezoelectric resonator was polarized in the thickness direction and vibrated in the longitudinal direction when a signal was applied to the electrodes.
The piezoelectric resonator shown in Fig. 9 had the same dimensions as the piezoelectric resonator shown in Fig. 8. Electrodes were formed on both surfaces in the longitudinal direction of a piezoelectric substrate. The piezoelectric resonator was polarized in the longitudinal direction and vibrated in the longitudinal direction when a signal was applied to the electrodes. The piezoelectric resonator shown in Fig. 10 was made by forming electrodes on both surfaces in the thickness direction of a piezoelectric substrate measuring 4.7 mm by 4.7 mm by 0.38 mm. This piezoelectric resonator was polarized in the thickness direction and vibrated in the plane direction when a signal was applied to the electrodes. The piezoelectric resonators shown in Figs. 8 and 10 were of unstiffened type and the piezoelectric resonator shown in Fig. 9 was of stiffened type.
The resonant frequency Fr and the electromechanical coupling coefficient K of each of these piezoelectric resonators were measured and the results are shown in Tables 1, 2, and 3. Table 1 indicates the measured results of the piezoelectric resonator shown in Fig. 8. Table 2 indicates the measured results of the piezoelectric resonator shown in Fig. 9. Table 3 indicates the measured results of the piezoelectric resonator shown in Fig. 10.

**Table 1**

| | Longitudinal basic vibration | Longitudinal triple-wave vibration | Width-mode vibration |
|---|---|---|---|
| Resonant frequency (MHz) | 0.460 | 1.32 | 1.95 |
| Electro-mechanical coupling coefficient (%) | 18.9 | 3.9 | 25.2 |

**Table 2**

| | Longitudinal basic vibration | Longitudinal triple-wave vibration | Width-mode vibration |
|---|---|---|---|
| Resonant frequency (MHz) | 0.455 | 1.44 | 1.96 |
| Electro-mechanical coupling coefficient (%) | 42.9 | 12.2 | 4.0 |

**Table 3**

| | Longitudinal basic vibration | Square-type triple-wave vibration | Thickness-mode vibration |
|---|---|---|---|
| Resonant frequency (MHz) | 0.458 | 1.25 | 5.65 |
| Electro-mechanical coupling coefficient (%) | 35.0 | 11.5 | 23.3 |

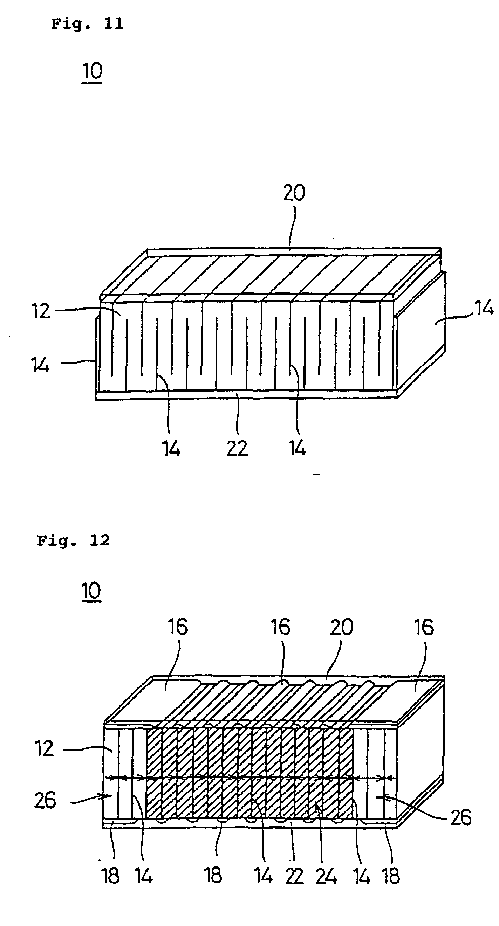

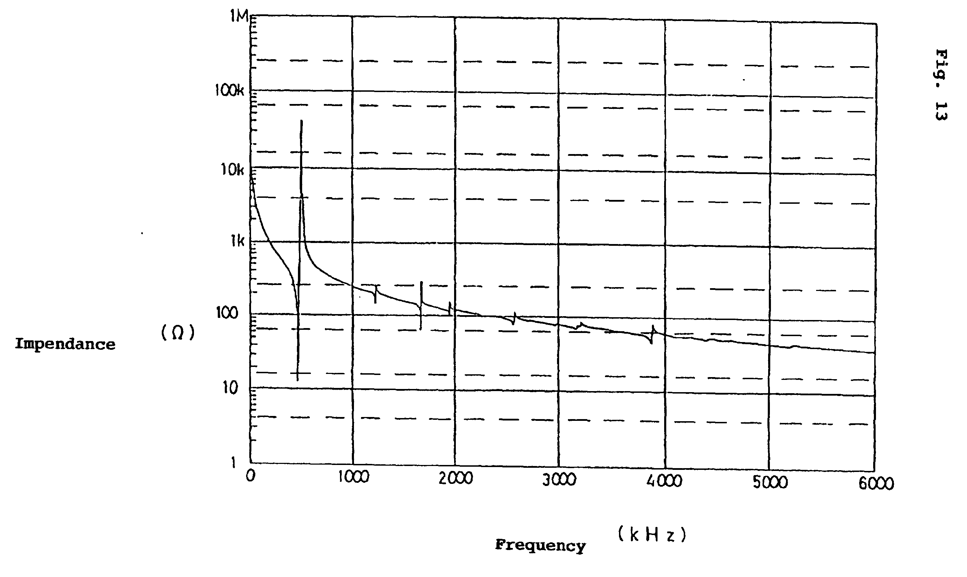

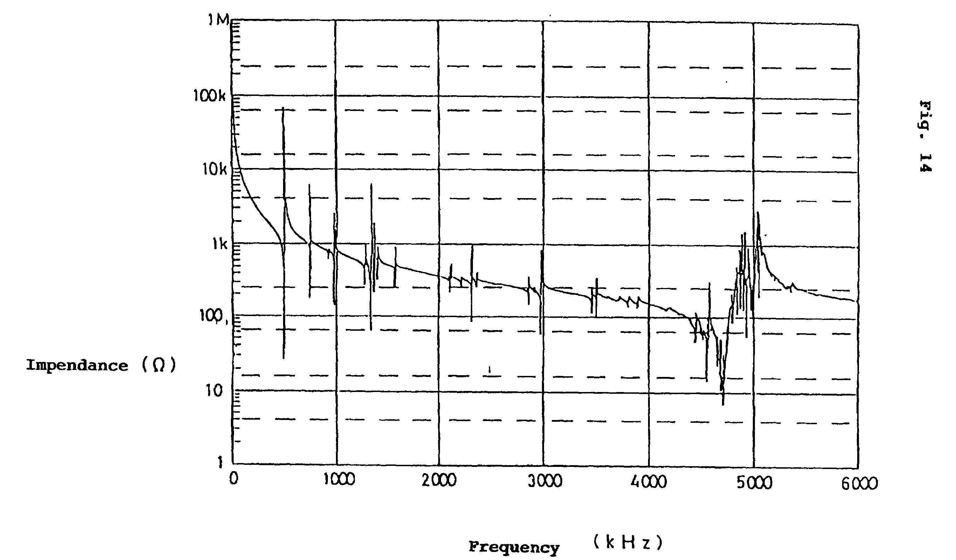

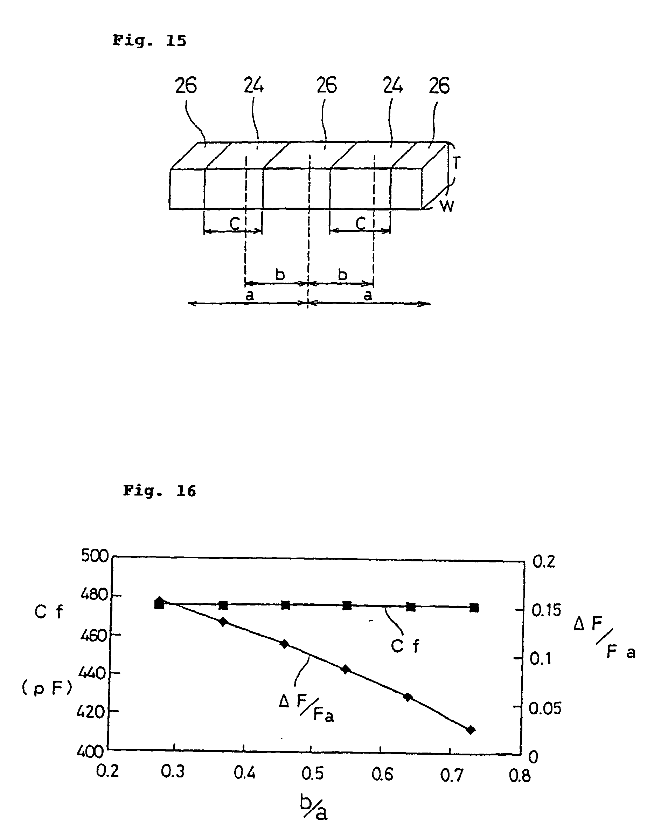

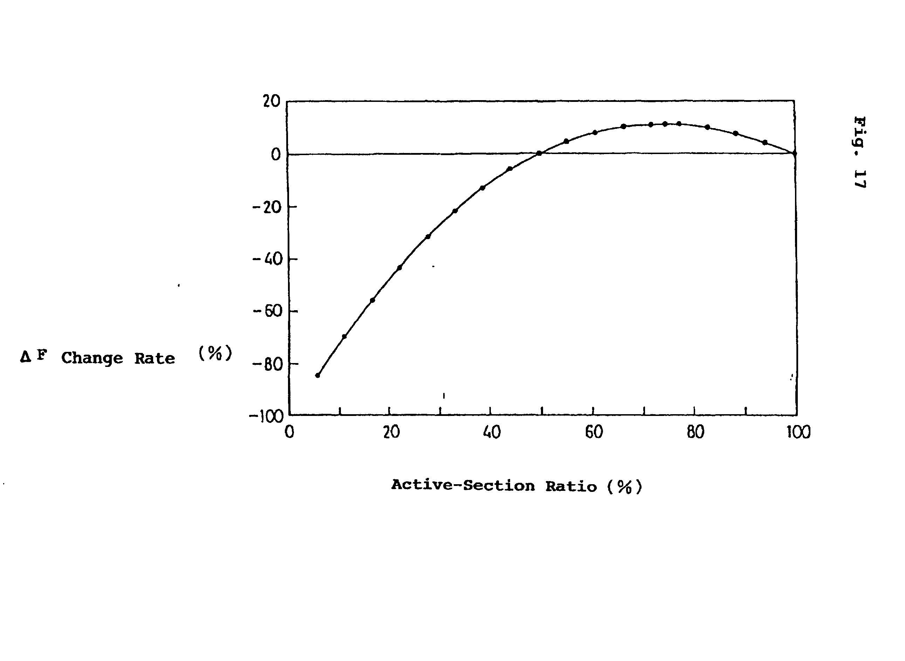

It is understood from the measurement data that a stiffened piezoelectric resonator has a larger electromechanical coupling coefficient K than an unstiffened piezoelectric resonator, and therefore has a larger frequency difference ΔF between the resonant frequency and the antiresonant frequency. The largest spurious vibration in a stiffened piezoelectric resonator is of longitudinal triple-wave type and the electromechanical coupling coefficient K is 12.2% during vibration. During width-mode vibration, which is different from basic vibration, the electromechanical coupling coefficient K is 4.0%. In contrast, the electromechanical coupling coefficient K during width-mode vibration is 25.2% in an unstiffened longitudinal-vibration piezoelectric resonator. In an unstiffened square-type vibration piezoelectric resonator, the electromechanical coupling coefficient K is as large as 23.3% during thickness-mode vibration. Therefore, it is understood that a stiffened piezoelectric resonator has smaller spurious vibrations than an unstiffened piezoelectric resonator.
In order to connect the electrodes 14 formed in the base member 12 to the external electrodes 20 and 22, internal electrodes 14 may reach the opposite side faces of the base member 12 alternately as shown in Fig. 11. On the opposite side faces of the base member 12, it is necessary to form external electrodes 20 and 22. In the piezoelectric resonator 10, since the electrodes 14 are exposed alternately, the alternate electrodes 14 are connected to the external electrodes 20 and 22, respectively, by forming the external electrodes 20 and 22 on the side faces of the base member 12. Therefore, there is no need to form insulating film on the side faces of the base member 12. An electrode 14 is not formed on the entire area of a cross section of the base member 12 in this piezoelectric resonator 10. Therefore, the opposing area of adjacent electrodes 14 is smaller than that of adjacent electrodes 14 formed on the entire cross section. By using the opposing area, the capacitance and ΔF of the piezoelectric resonator 10 can be adjusted.
As shown in Fig. 12, an active section which is piezoelectrically active and an inactive section which is piezoelectrically inactive can be formed in the base member 12 of the piezoelectric resonator 10. In this case, for example, electrodes 14 are not formed at both end faces of the base member 12, and some electrodes 14 disposed near both ends of the base member 12 are successively covered by the insulating films 16 and 18. In this embodiment, three consecutive electrodes 14 from each end of the base member 12 are covered by the insulating film 16, and two consecutive electrodes 14 from each end of the base member 12 are covered by the insulating film 18. External electrodes 20 and 22 are formed on the side faces of the base member 12 on which the insulating films 16 and 18 are formed. The internal electrodes 14 thereby connect to the external electrodes 20 and 22. Some of the electrodes 14 disposed at both ends of the base member 12 are, however, not connected to the external electrodes 20 and 22.
At the center of the base member 12, the base member 12 is piezoelectrically active because an electric field is applied between adjacent electrodes 14. The base member 12 is piezoelectrically inactive at both ends because an electric field is not applied between adjacent electrodes 14 since the electrodes 14 are insulated. Therefore, an active section 24 for input signals is formed at the center of the base member 12 as shown by hatching in Fig. 12. Inactive sections 26 for input signals are also formed at both ends of the base member 12.
In the piezoelectric resonator 10, the inactive section 26 is formed at both ends of the base member 12. The inactive section 26 is changed to adjust the resonant frequency and the difference ΔF between the resonant frequency and the antiresonant frequency. In other words, by grinding the end faces in the longitudinal direction of the base member 12 or by adding mass, the resonant frequency and/or the antiresonant frequency of the piezoelectric resonator 10 can be adjusted.
In the piezoelectric resonator 10, as described before, the capacitance of the resonator can be adjusted by, for example, changing the number of layers in the base member 12. In the base member 12, the piezoelectric layers and electrodes 14 are alternately stacked and electrically connected in parallel. When the number of layers is changed with the total length of the base member 12 remaining constant, the following relationship is satisfied since the thickness of one layer is inversely proportional to the number of layers.
Capacitance of resonator is proportional to (the number of layers in active section/thickness of a layer) and, in turn, is proportional to (the number of layers in active section)²
The capacitance of the resonator is proportional to the square of the number of layers in the active section of the base member 12. Therefore, the number of layers in the active section of the base member 12 is changed to adjust the capacitance of the piezoelectric resonator 10. This means that the piezoelectric resonator 10 has a high degree of freedom in capacitance design. Therefore, it is easy to achieve impedance matching with an external circuit when the piezoelectric resonator 10 is mounted on a circuit board and used.
Electrically conductive paste including, for example, silver, palladium, and an organic binder, was applied to one surface of each green sheet 30 made from piezoelectric ceramic. A plurality of such green sheets were stacked alternately and baked integrally at 1200 °C to form a laminated block 34 measuring 20 mm by 30 mm by 3.9 mm. External electrodes 38 and 40 were formed by sputtering. A high DC electric field was applied between adjacent internal electrodes 36 to polarize the laminated block such that the directions of polarization in adjacent piezoelectric layers were alternately opposed. The thickness of the laminated block 34 was changed. The laminated block 34 was cut to form a plate-shaped block 42 measuring 1.5 mm by 30 mm by 3.8 mm. Every other electrodes 36 exposed at the side faces of the plate-shaped block 42 were covered by a resin insulating material 44 and a silver electrode was formed on it by sputtering. The resultant block was cut by a dicing machine to obtain a piezoelectric resonator 10 measuring 1.5 mm by 1.5 mm by 3.8 mm.
The piezoelectric resonator 10 had nineteen electrodes 14 in the base member 12, the electrodes 14 being disposed at an almost equal interval of 0.19 mm. Insulating films 16 and 18 were formed so as to avoid applying an electric field to three piezoelectric layers disposed at both ends of the base member 12. An active section 24 included 14 piezoelectric layers disposed at the center of the base member 12, and an inactive section 26 had three piezoelectric layers at both ends. The piezoelectric resonator 10 had a capacitance of 830 pF and the frequency characteristics shown in Fig. 13. For comparison, the frequency characteristics of a square-type vibration piezoelectric resonator is shown in Fig. 14. It is found from Figs. 13 and 14 that the piezoelectric resonator 10 according to the present invention has much less spurious vibration than the square-shaped piezoelectric resonator. Depending on the positions where active sections 24 and inactive sections 26 are formed, the frequency difference ΔF between the resonant frequency and the antiresonant frequency changes. Inactive sections 26 can be formed, for example as shown in Fig. 15, at both ends and the center of the base member 12. The finite element method was used to calculate changes in capacitance Cf and frequency difference ΔF in the piezoelectric resonator in a case in which the positions where active sections were formed change, where "a" indicates the distance between the center and an end of the piezoelectric resonator 10, "b" indicates the distance between the center and the center of gravity of an active section 24, "c" indicates the length of the active sections 24, W indicates the width of the base member 12, and T indicates the thickness of the base member 12. Fig. 16 shows the relationship between b/a, and the ratio of ΔF to the antiresonant frequency Fa, ΔF/Fa, and the capacitance Cf with "a" being equal to 1.89 mm, W and T equal to 0.8 mm, "c" equal to 0.86 mm, and b/a changing. From Fig. 16, it is found that the capacitance Cf does not change irrespective of the positions where the active sections 24 were formed.
In contrast, it was also found that ΔF decreases as the active sections approach both ends of the base member 12.
The frequency difference ΔF can be changed in the piezoelectric resonator 10 by changing the ratio of the active sections 24 to the inactive sections 26. With a changing active-section ratio, which is a ratio of the length of the active section 24 to that of the base member 12 in the piezoelectric resonator 10 shown in Fig. 12, the resonant frequency Fr, the antiresonant frequency Fa, the frequency difference ΔF, and its rate of change were measured and are indicated in Table 4 and Fig. 17.

**Table 4**

| Active-section length (mm) | Active-section ratio (%) | Fr (kHz) | Fa (kHz) | ΔF (kHz) | ΔF change rate (%) |
|---|---|---|---|---|---|
| 1.80 | 100.0 | 1047.4 | 1163.4 | 115.9 | 0.0 |
| 1.70 | 94.4 | 1042.4 | 1163.4 | 120.9 | 4.3 |
| 1.60 | 88.9 | 1038.6 | 1163.4 | 124.8 | 7.6 |
| 1.53 | 85.0 | 1036.6 | 1163.4 | 126.8 | 9.4 |
| 1.50 | 83.3 | 1035.9 | 1163.4 | 127.5 | 9.9 |
| 1.40 | 77.8 | 1034.5 | 1163.4 | 128.9 | 11.2 |
| 1.35 | 75.0 | 1034.3 | 1163.4 | 129.1 | 11.4 |
| 1.30 | 72.2 | 1034.3 | 1163.4 | 129.0 | 11.3 |
| 1.20 | 66.7 | 1035.5 | 1163.4 | 127.9 | 10.3 |
| 1.17 | 65.0 | 1036.1 | 1163.4 | 127.2 | 9.7 |
| 1.10 | 61.1 | 1038.1 | 1163.4 | 125.3 | 8.1 |
| 1.00 | 55.6 | 1042.0 | 1163.4 | 121.4 | 4.7 |
| 0.90 | 50.0 | 1047.4 | 1163.4 | 115.9 | 0.0 |
| 0.80 | 44.4 | 1054.3 | 1163.4 | 109.1 | -5.9 |
| 0.70 | 38.9 | 1062.7 | 1163.4 | 100.6 | -13.2 |
| 0.60 | 33.3 | 1072.7 | 1163.4 | 90.7 | -21.8 |
| 0.50 | 27.8 | 1084.2 | 1163.4 | 79.1 | -31.7 |
| 0.40 | 22.2 | 1097.3 | 1163.4 | 66.1 | -43.0 |
| 0.30 | 16.7 | 1111.9 | 1163.4 | 51.5 | -55.6 |
| 0.20 | 11.1 | 1127.9 | 1163.4 | 35.5 | -69.4 |
| 0.10 | 5.6 | 1145.2 | 1163.4 | 18.2 | -84.3 |

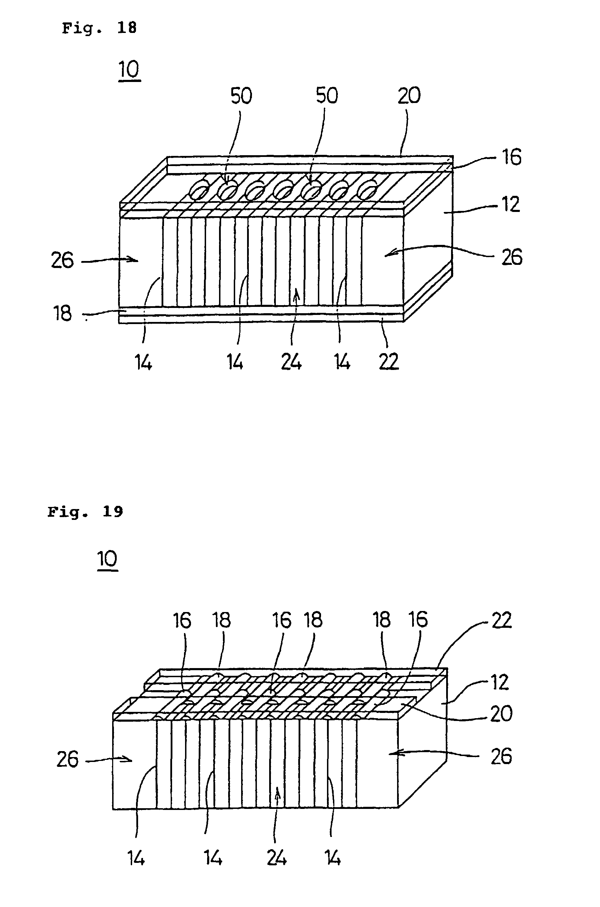

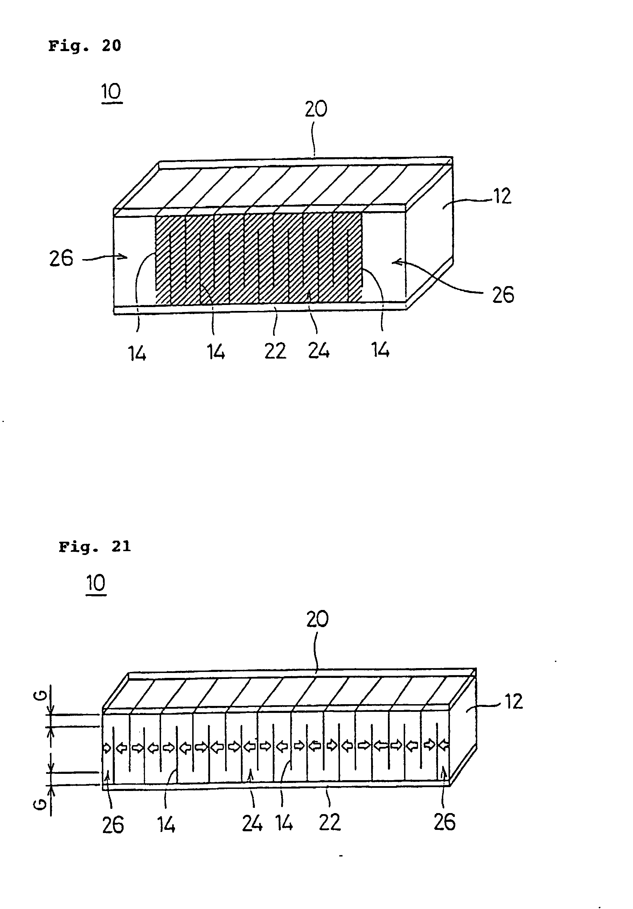

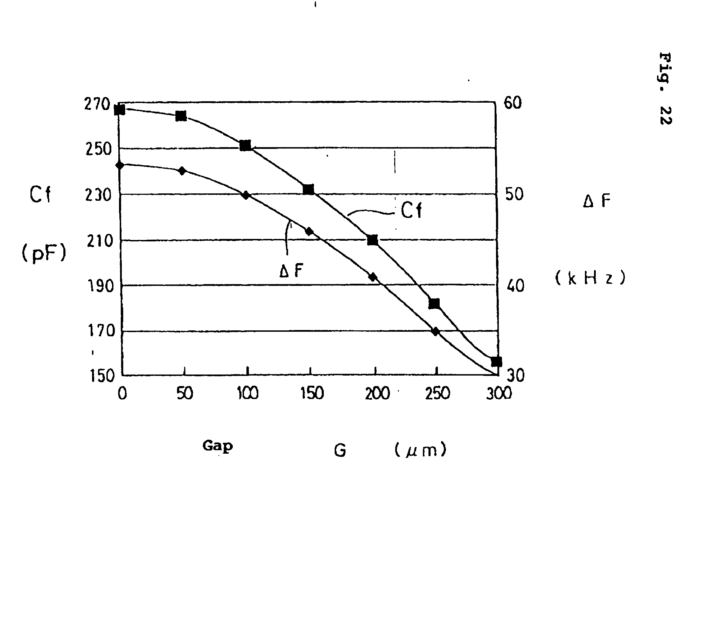

Fig. 17 shows the relationship between the active-section ratio and change in ΔF under the condition in which ΔF is set to 100% when the active-section ratio is 100%, namely when an inactive section does not exist. It is found from Fig. 17 that ΔF is large at an active-section ratio of 65% to 85% with the peak ΔF being obtained at an active-section ratio of 75%. The peak value is larger by about 10% than the ΔF obtained when the active-section ratio is 100%, in other words, when an inactive section does not exist. The same ΔF is obtained at active-section ratios of 50% and 100%. Therefore, to obtain a piezoelectric resonator having a large ΔF, it is necessary to set the active-section ratio to 50% or more.
In the piezoelectric resonator 10, when 14 piezoelectric layers constituted the active section 24 among 20 layers, the capacitance was 830 pF. In contrast, when the active-section ratio was set to 100%, which means that only one piezoelectric layer was used, in other words, when electrodes were formed at both end faces of the base member 12, with the same material and the same dimensions, the capacitance was 3.0 pF. When all of the 24 piezoelectric layers constituted the active section 24, the capacitance was 1185.6 pF. By changing the number of piezoelectric layers in the active section 24 of the base member 12 in the piezoelectric resonator 10, the capacitance can be changed within a range of about 400-times difference between the minimum and maximum. Therefore, by changing the lamination structure of the piezoelectric resonator 10, the capacitance can be selected from a wide range which provides a large degree of freedom in capacitance design.
In order to connect the electrodes 14 formed inside the base member 12 to the external electrodes 20 and 22, insulating films 16 and 18 having windows 50 may be provided such that every other electrode 14 is exposed as shown in Fig. 18. The external electrodes 20 and 22 are formed on the insulating films 16 and 18, and the electrodes 14 connect to the two external electrodes 20 and 22 alternately. Two external electrodes 20 and 22 may be formed on one side face of the base member 12 as shown in Fig. 19. Insulating films 16 and 18 are formed on one side face of the base member 12 in a two-row manner and two rows of connection sections are formed. These two rows of insulating films 16 and 18 are formed respectively on every other electrode 14. On these two rows of insulating film 16 and 18, two rows of external electrodes 20 and 22 are formed, respectively. The piezoelectric resonators having these modifications can achieve the same advantages as the above-described piezoelectric resonator. Also in the piezoelectric resonator 10 in which internal electrodes 14 are alternately exposed to side faces of the base member 12 as shown in Fig. 20, an active section 24 and inactive sections 26 can be formed.
The capacitance and ΔF of the piezoelectric resonator 10 in which internal electrodes 14 are alternately exposed as shown in Fig. 20 can be changed by adjusting the opposing areas of adjacent electrodes 14. Using the finite element method, with the gap G between the end of an electrode 14 and the side face of the base member 12 in the thickness direction being changed, the antiresonant frequency Fa, capacitance Cf, and ΔF of a piezoelectric resonator having a base member 12 which is 3.74 mm long, 0.8 mm wide, 1.0 mm thick, and having an active section 24 3.6 mm long, inactive sections 26 disposed at both ends 0.07 mm long and 20 piezoelectric layers each 0.18 mm thick, as shown in Fig. 21, were calculated. The results are shown in Table 5 and Fig. 22. It is found from Table 5 and Fig. 22 that Cf and ΔF become smaller as the gap G increases, in other words, as the opposite area of the electrodes 14 becomes smaller.

**Table 5**

| Gap G (mm) | Fa (kHz) | Fa change rate (%) | Cf (pF) | Cf change rate (%) | ΔF (kHz) | ΔF change rate (%) |
|---|---|---|---|---|---|---|
| 1 | 546.37 | -0.52 | 267.58 | 27.47 | 53.36 | 30.15 |
| 50 | 546.75 | -0.45 | 264.40 | 25.96 | 52.71 | 28.56 |
| 100 | 547.38 | -0.33 | 251.69 | 19.90 | 50.05 | 22.07 |
| 150 | 548.20 | -0.18 | 232.38 | 10.70 | 45.89 | 11.93 |
| 200 | 549.20 | 0.00 | 209.91 | 0.00 | 41.00 | 0.00 |
| 250 | 550.61 | 0.26 | 181.96 | -13.32 | 35.06 | -14.49 |
| 300 | 552.11 | 0.53 | 156.44 | -25.47 | 29.75 | -27.44 |

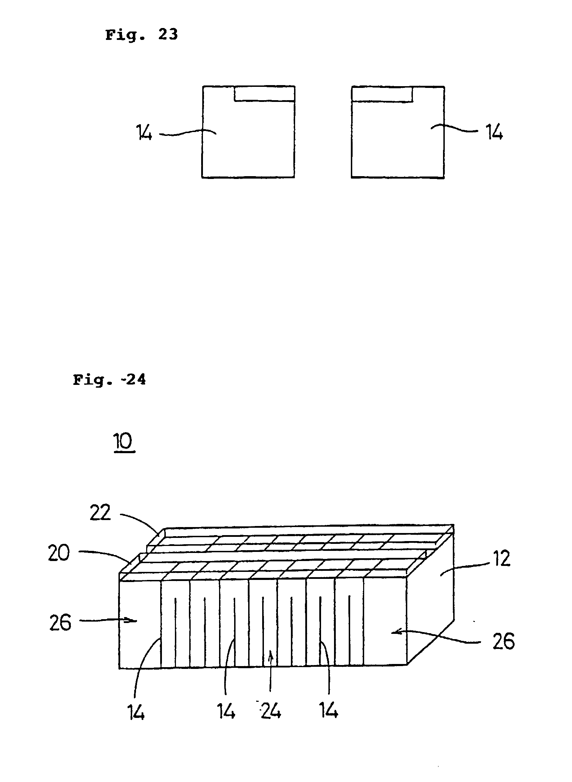

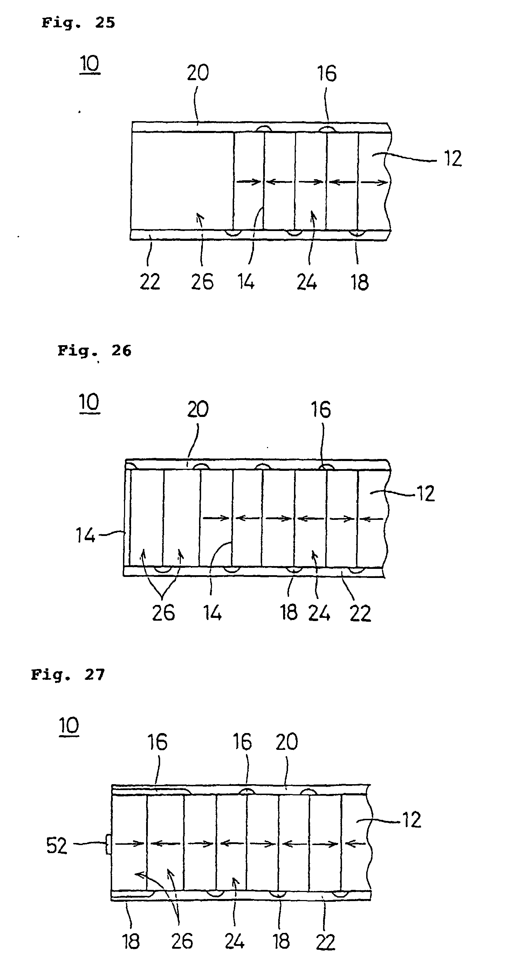

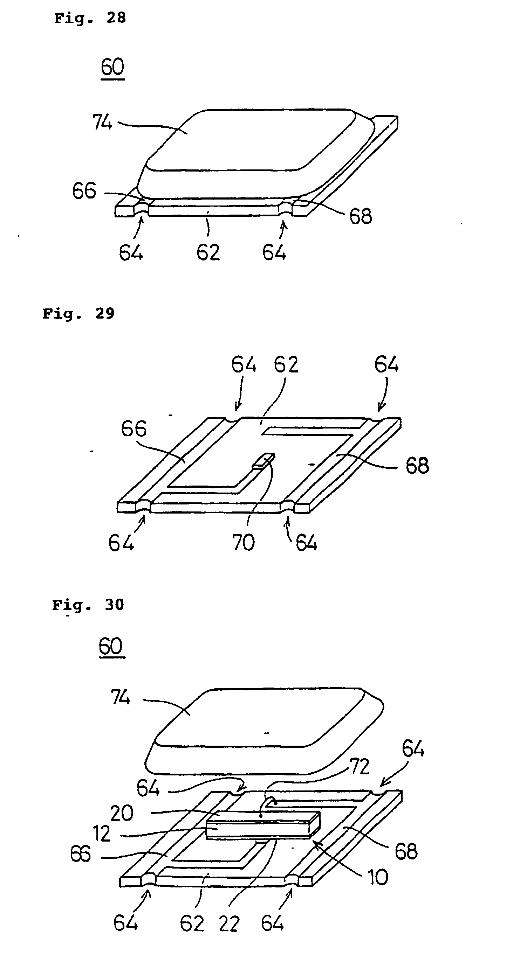

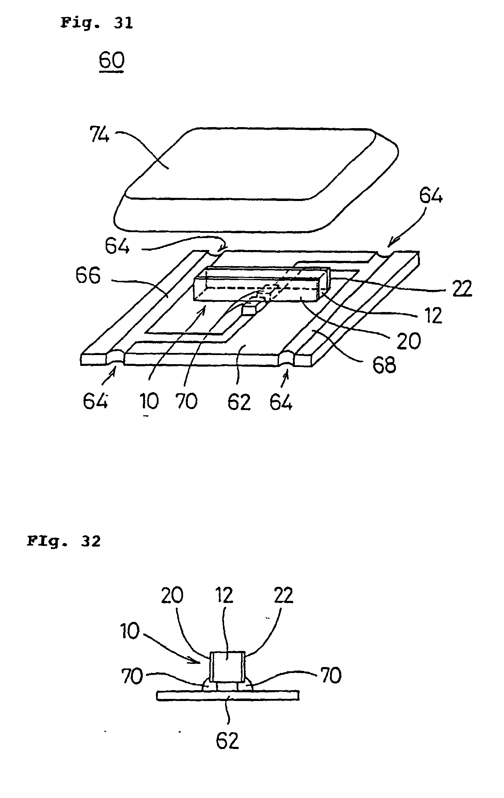

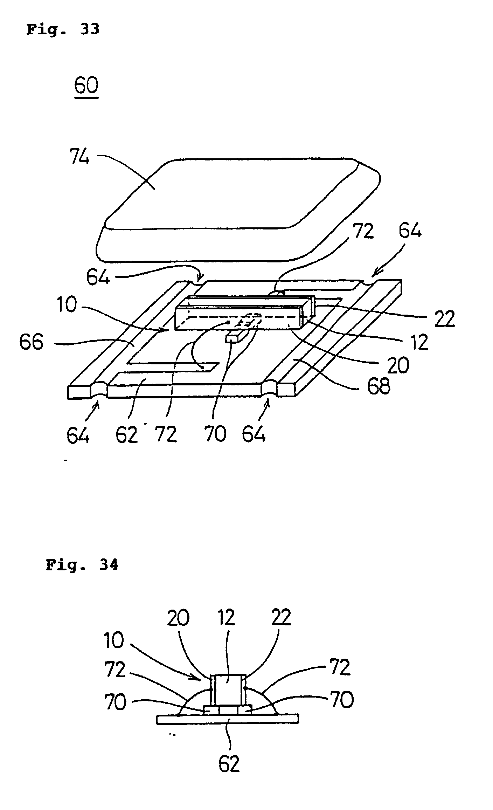

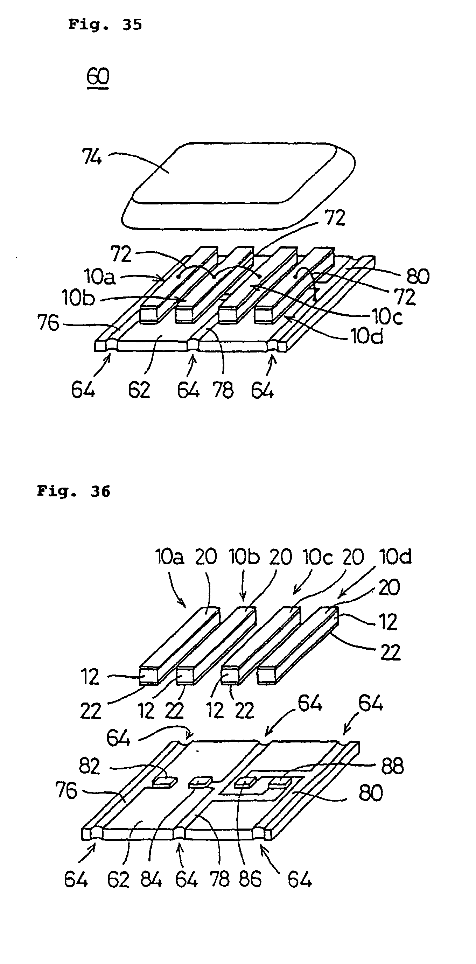

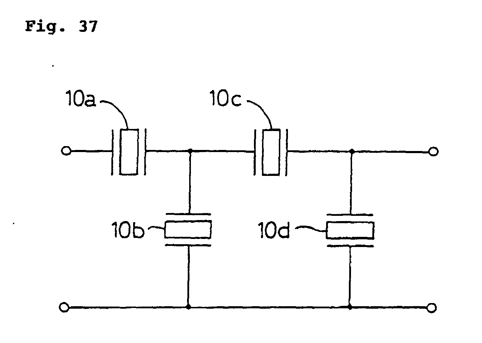

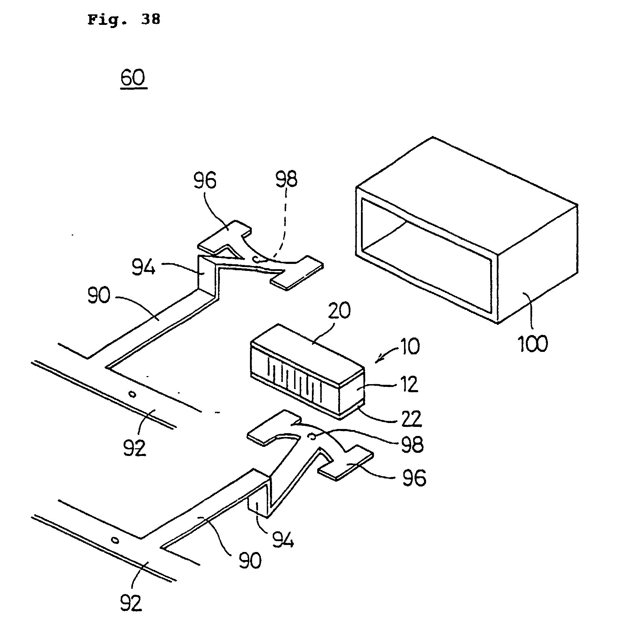

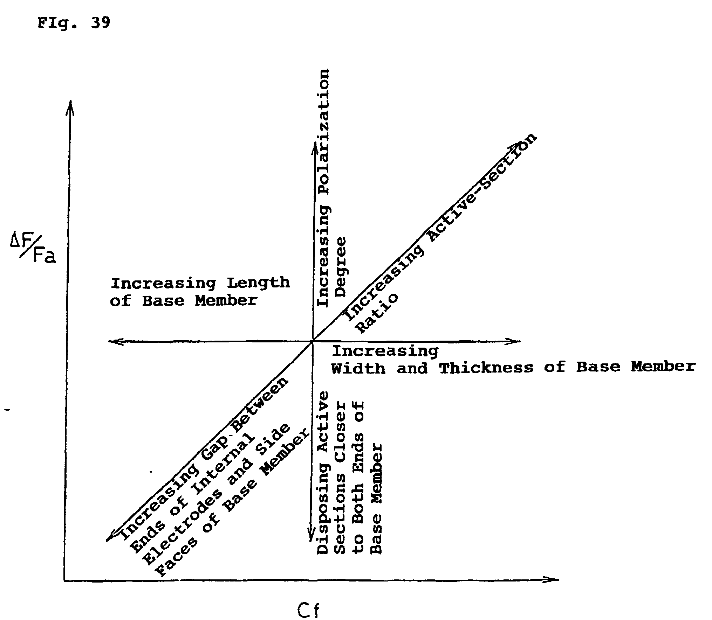

Electrodes 14 may be formed such that they reach different end faces on the same side of piezoelectric layers as shown in Fig. 23 in a piezoelectric resonator 10 which is a modified example of the above-described piezoelectric resonator 10. By laminating these two types of piezoelectric layers, two rows of electrodes 14 are exposed on one side face of the base member 12 as shown in Fig. 24. Therefore, by forming external electrodes 20 and 22 at portions where the electrodes 14 are exposed, the electrodes 14 are alternately connected to the external electrodes 20 and 22.
In the piezoelectric resonator 10 in which each electrode 14 is formed over the entire cross section of the base member 12 as shown in Figs. 2 and 12, since an electric field is applied to the entire cross section of the base member 12, the electromechanical coupling coefficient of the resonator is large and thus ΔF is large.
The capacitance of the piezoelectric resonator 10 is also large. When the laminated block is cut to produce a plurality of the piezoelectric resonators 10, since each electrode has been formed over almost the entire cross section of the laminated block in advance, each piezoelectric resonator has an electrode over the entire cross section even if the cut position shifts. Therefore, it is not necessary to precisely determine the positions at which the laminated block is cut. By changing the direction of cutting, resonators having different cross sections, different areas, and different capacitances are obtained from the same piezoelectric, ceramic, laminated block. Resonators having various capacitances and various ΔF can be obtained according to which electrode end section has insulating film. As described above, many types of piezoelectric resonators can be obtained from the same laminated block.
In contrast, to produce a piezoelectric resonator having a gap between an end of each electrode 14 and the side face of the base member 12 as shown in Figs. 11 and 20, it is necessary to cut a laminated block after positioning such that the gap is correctly formed. In such a piezoelectric resonator, however, it is not necessary to form insulating film on a side face of a base member, and the number of manufacturing processes can be reduced.
An inactive section 26 may be formed such that an electric field is not applied by not forming electrodes 14 at an end of the base member 12 as shown in Fig. 25. The end of the base member 12 may be polarized or may not be polarized. As shown in Fig. 26, only the end of the base member 12 may not be polarized. In this case, even if an electric field is applied between the electrodes 14, a portion not polarized is piezoelectrically Inactive. In other words, only when a piezoelectric layer is polarized and an electric field is applied, the layer becomes piezoelectrically active, otherwise it is inactive. In this configuration, the capacitor is formed in the inactive section, and the capacitance can be increased. A small electrode 52 may be formed on an end face of the base member 12 as shown in Fig. 27 in order to adjust the frequency or to connect to an external circuit.
Using such a piezoelectric resonator 10, electronic components such as oscillators and discriminators are produced. Fig. 28 is a perspective view of an electronic component 60. The electronic component 60 includes an insulating substrate 62 served as a support member. At opposing end portions of the insulating substrate 62, two indentations 64 are formed, respectively. On one surface of the insulating substrate 62, two pattern electrodes 66 and 68 are formed as shown in Fig. 29. One pattern electrode 66 is formed between opposing indentations and extends in an L-shaped manner from a point near one end toward the center of the insulating substrate 62. The other pattern electrode 68 is formed between opposing indentations 64 and extends straight from a point near the other end toward the center of the insulating substrate 62. The pattern electrodes 66 and 68 are formed such that they are routed in a roundabout fashion from the ends of the insulating substrate 62 to the opposite surface.
At one end of the pattern electrode 66 disposed at the center of the insulating substrate 62, a protrusion 70 served as a mounting member is formed with electrically conductive adhesive. As shown in Fig. 30, the above-described piezoelectric resonator 10 is mounted on the protrusion 70 such that the center of the base member 12 is disposed on the protrusion 70. An external electrode 22 of the piezoelectric resonator 10 is, for example, connected to the protrusion 70. The other external electrode 20 is connected to a pattern electrode 68 with electrically conductive wire 72. The electrically conductive wire 72 is connected to the center of the external electrode 20 of the piezoelectric resonator 10. The protrusion 70 may be formed on the piezoelectric resonator 10. In this case, the protrusion 70 provided for the piezoelectric resonator 10 is mounted to the pattern electrode 66 with electrically conductive adhesive.
A metal cap 74 is placed on the insulating substrate 62 to complete the electronic component 60. To prevent the metal cap 74 from being short-circuited to the pattern electrodes 66 and 68, insulating resin is applied to the insulating substrate 62 and the pattern electrodes 66 and 68 in advance. The electronic component 60 uses the pattern electrodes 66 and 68, which are formed such that they are routed to the rear surface from ends of the insulating substrate 62, as input and output terminals for connecting to external circuits.
Since the center of the piezoelectric resonator 10 is connected to the protrusion 70 in this electronic component 60, the ends of the piezoelectric resonator 10 are disposed separately from the insulating substrate 62 so vibration is not prevented. Excited longitudinal vibration is not weakened because the center of the piezoelectric resonator, which serves as a node, is secured to the protrusion 70 and is connected to the electrically conductive wire 72.
The electronic component 60 is mounted on a circuit board together with IC chips and other components to form an oscillator and a discriminator. Since the electronic component 60 is sealed and protected by the metal cap 74, it can be used as a chip-type (surface mount) component which can be mounted by reflow soldering.
When the electronic component 60 is used in an oscillator, spurious vibrations are suppressed to a low level and unusual vibration caused by the spurious vibrations are prevented due to the features of the piezoelectric resonator 10 used in the electronic component 60. It is also easy to achieve impedance matching with an external circuit since the capacitance of the piezoelectric resonator 10 can be set to any desired value. Especially when the electronic component is used for an oscillator for voltage-controlled oscillation, a wide frequency range which cannot be obtained conventionally is acquired due to a large ΔF of the resonator.
When the electronic component 60 is used for a discriminator, a wide peak-separation range is provided due to a large ΔF of the resonator. In addition, since the resonator provides a wide capacitance range, it is easy to achieve impedance matching with an external circuit.
The piezoelectric resonator 10 may be mounted on the insulating substrate 62 so that two protrusions 70 made from an electrically conductive material such as electrically conductive adhesive are formed on both pattern electrodes 66 and 68, and the external electrodes 20 and 22 of the piezoelectric resonator 10 are connected to the two protrusions 70, as shown in Figs. 31 and 32. The piezoelectric resonator 10 may also be mounted on the insulating substrate 62 in a way shown in Figs. 33 and 34 in which two protrusions 70 made from an insulating material such as insulating adhesive are formed on the insulating substrate 62 and the external electrodes 20 and 22 are connected to the pattern electrodes 66 and 68 with electrically conductive wire 72.
A ladder filter can be made using a plurality of the piezoelectric resonators 10. As shown in Figs. 35 and 36, three pattern electrodes 76, 78, and 80 are formed on an insulating substrate 62 in this electronic component 60. Protrusions 82 and 86 are formed with electrically conductive adhesive on both-end pattern electrodes 76 and 80. On the center pattern electrode 78, two protrusions 84 and 88 are formed with electrically conductive adhesive.
One external electrode 22 for each of piezoelectric resonators 10a, 10b, 10c, and 10d is mounted to each of the protrusions 82, 84, 86, and 88, respectively. The other external electrodes 20 for piezoelectric resonators 10a, 10b, and 10c are connected to each other with electrically conductive wire 72. The other external electrode 20 of a piezoelectric resonator 10d is connected to the pattern electrode 80 with electrically conductive wire 72. A metal cap 74 is placed on the insulating substrate 62.
The electronic component 60 is used as a ladder filter having a ladder-shaped circuit shown in Fig. 37. Two piezoelectric resonators 10a and 10c serve as series resonators and the other two piezoelectric resonator 10c and 10d serve as parallel resonators. In such a ladder filter, the parallel piezoelectric resonators 10b and 10d are designed to have substantially larger capacitances than the series piezoelectric resonators 10a and 10c.
Attenuation in the ladder filter is determined by the capacitance ratio between the series resonators and the parallel resonators. In this electronic component 60, the capacitance can be adjusted by changing the number of laminated layers used in the piezoelectric resonators 10a to 10d. Therefore, a ladder filter having a larger attenuation with fewer resonators is implemented by changing the capacitances of the piezoelectric resonators, as compared with a case where the conventional unstiffened piezoelectric resonators are used. Since the piezoelectric resonators 10a to 10d have a larger ΔF than the conventional piezoelectric resonator, a wider transmission frequency band is implemented as compared with the conventional piezoelectric resonator.
A two-terminal electronic component 60 such as a resonator and a discriminator can be produced with a piezoelectric resonator 10 as shown in Fig. 38. Two terminals 90 made from an electrically conductive material are prepared to produce such a two-terminal component 60. These terminals 90 are formed such that they extend from hoops 92. Practically, a plurality of terminals 90 are formed on each hoop 92 in line. A terminal 90 is provided with a fold section 94 at the intermediate portion and an H-shaped support member 96 at the end. The support member 96 is bent and is provided with a protruded mounting member 98 at the center. The two terminals 90 are disposed such that their mounting members 98 oppose each other.
The piezoelectric resonator 10 is supported between the mounting members 98.
The mounting members 98 abut against the external electrodes 20 and 22 at the center of the piezoelectric resonator in the longitudinal direction. Since the terminals 90 have fold sections 94, which serve as spring elements, the piezoelectric resonator 10 is spring-supported by the terminals 90. A case 100 having an opening at one end is placed on the piezoelectric resonator 10. The opening of the case 100 is closed with paper and then resin-sealed. The terminals 90 are cut from the hoops 92 to complete the electronic component 60. The electronic component 60 having a shape other than a chip-shape can thus be made.
Since the base member 12 has a lamination structure, the capacitance of the piezoelectric resonator 10 according to the present invention can be set to any desired value and it is easy to achieve impedance matching with an external circuit. Since the present invention employs a stiffened piezoelectric resonator, the resonator has a larger ΔF and a wider frequency band than the conventional unstiffened piezoelectric resonator. In addition, the stiffened piezoelectric resonator has small spurious vibrations. Furthermore, by adjusting the sizes and positions of the active section and the inactive sections, ΔF can be changed. Since the electronic component 60 according to the present invention has a simple structure, it can be produced at a low cost while exhibiting the above-described features of the piezoelectric resonator 10.
Since the piezoelectric resonator 10 according to the present invention includes more parameters which can be designed than the conventional piezoelectric resonator, various characteristics can be implemented. The relationships between these parameters, ΔF/Fa and capacitance Cf are indicated in Fig. 39. It is understood from Fig. 39 that these parameters extend the degree of freedom in designing the characteristics of the piezoelectric resonator 10.

## Claims

1. A piezoelectric resonator (10) comprising
- a base member (12) having a longitudinal direction,
- an active section (24) composed of polarized piezoelectric member and constituting at least a part of said base member (26),
- a pair of external electrodes (20, 22) provided with said active section,
- a plurality of internal electrodes (14) being disposed in/on said active section (24) so as to be perpendicular to the longitudinal direction of said base member (12) and connected to said external electrodes (20, 22),
- said base member including a structure in which a plurality of piezoelectric layers and said plurality of internal electrodes (14) are alternately laminated, and
- a longitudinal basic vibration being excited when an AC electric field in the longitudinal direction of said base member (12) is applied to said active section via said plurality of internal electrodes (14),
**characterized in that**
- each of said plurality of internal electrodes (14) entirely covers a cross section of said base member (12) perpendicular to the longitudinal direction of said base member (12),
- one pair of connecting sections in which exposed portions of alternate said internal electrodes (14) are covered by insulating films (16, 18) respectively, and
- said one pair of external electrodes (20, 22) are provided on said one pair of connecting sections such that adjacent internal electrodes (14) among said plurality of internal electrodes (14) are connected to said pair of external electrodes (20, 22), respectively.

2. A piezoelectric resonator (10) according to claim 1, **characterized in that** said plurality of piezoelectric layers are polarized in opposite directions at both sides of said plurality of internal electrodes (14) in the longitudinal direction of said base member (12), and adjacent internal electrodes (14) among said plurality of internal electrodes (14) are connected to said one pair of external electrodes (20, 22), respectively.

3. A piezoelectric resonator (10) according to claim 1 or 2, **characterized in that** said plurality of internal electrodes (14) are partially exposed at side faces of said base member (12), and the exposed portions of adjacent internal electrodes (14) among said plurality of internal electrodes (14) are connected to said pair of external electrodes (20, 22), respectively.

## Patentansprüche

1. Piezoelektrischer Resonator (10), umfassend
- ein Basisglied (12), welches eine Längsrichtung aufweist,
- eine aktive Partie (24), welche aus einem polarisierten piezoelektrischen Glied zusammengesetzt ist und wenigstens einen Abschnitt des Basisglieds (26) ausmacht,
- ein externes Elektrodenpaar (20, 22), welches mit der aktiven Partie bereitgestellt wird,
- mehrere interne Elektroden (14), welche in/auf der aktiven Partie (24) so angeordnet sind, daß sie senkrecht zur Längsrichtung des Basisglieds (12) sind und mit den externen Elektroden (20, 22) verbunden sind,
- wobei das Basisglied eine Struktur umfaßt, bei welcher mehrere piezoelektrische Schichten und die mehreren internen Elektroden (14) abwechselnd geschichtet sind, und
- wobei eine longitudinale Grundschwingung erregt wird, wenn ein elektrisches Wechselfeld in der Längsrichtung des Basisglieds (12) über die mehreren internen Elektroden (14) an die aktive Partie angelegt wird,
**dadurch gekennzeichnet, daß**
- jede der mehreren internen Elektroden (14) einen Querschnitt des Basisglieds (12) senkrecht zur Längsrichtung des Basisglieds (12) vollständig abdeckt,
- ein Paar verbindender Partien vorgesehen ist, in welchen jeweils die ungeschützten Abschnitte sich abwechselnder interner Elektroden (14) mit Isolierfilmen (16, 18) bedeckt sind, und
- das eine Paar externer Elektroden (20, 22) auf dem einen Paar verbindender Partien derart vorgesehen ist, daß benachbarte interne Elektroden (14) der Vielzahl von internen Elektroden (14) mit jeweils einer des externen Elektrodenpaares (20, 22) verbunden sind.

2. Piezoelektrischer Resonator (10) nach Anspruch 1, **dadurch gekennzeichnet, daß** die mehreren piezoelektrischen Schichten an beiden Seiten der mehreren internen Elektroden (14) in entgegengesetzter Richtung in der Längsrichtung des Basisglieds (12) polarisiert sind, und benachbarte interne Elektroden (14) der mehreren internen Elektroden (14) mit jeweils einer des externen Elektrodenpaares (20, 22) verbunden sind.

3. Piezoelektrischer Resonator (10) nach Anspruch 1 oder 2, **dadurch gekennzeichnet, daß** die mehreren internen Elektroden (14) an den Seitenflächen des Basisglieds (12) teilweise ungeschützt sind, und die ungeschützten Abschnitte benachbarter interner Elektroden (14) der mehreren internen Elektroden (14) mit jeweils einer des externen Elektrodenpaares (20, 22) verbunden sind.

## Revendications

1. Résonateur piézoélectrique (10) comprenant
- un élément de base (12) ayant une direction longitudinale,
- une section active (24) constituée d'un élément piézoélectrique polarisé et constituant au moins une partie dudit élément de base (26),
- deux électrodes externes (20, 22) munies de ladite section active,
- plusieurs électrodes internes (14) étant disposées dans/sur ladite section active (24) de manière à être perpendiculaires à la direction longitudinale dudit élément de base (12) et sont connectées auxdites électrodes externes (20, 22),
- ledit élément de base incluant une structure dans laquelle plusieurs couches piézoélectriques et plusieurs électrodes internes (14) sont laminées en alternance, et
- une vibration basique longitudinale étant excitée lorsqu'un champ électrique de courant alternatif dans la direction longitudinale dudit élément de base (12) est appliqué à ladite section active par ladite pluralité d'électrodes internes (14),
**caractérisé en ce que**
- chacune de ladite pluralité d'électrodes internes (14) couvre entièrement une section transversale dudit élément de base (12) perpendiculaire à la direction longitudinale dudit élément de base (12),
- deux sections de connexion dans lesquelles des portions exposées desdites électrodes internes alternatives (14) sont recouvertes par des films isolants (16, 18) respectivement, et
- les deux électrodes externes précitées (20, 22) sont prévues sur les deux sections de connexion précitées de façon que des électrodes internes adjacentes (14) parmi ladite pluralité d'électrodes internes (14) sont connectées à ladite paire d'électrodes externes (20, 22), respectivement.

2. Résonateur piézoélectrique (10) selon la revendication 1, **caractérisé en ce que** plusieurs couches piézoélectriques sont polarisées dans des directions opposées aux deux côtés de ladite pluralité d'électrodes internes (14) dans la direction longitudinale dudit élément de base (12), et des électrodes internes adjacentes (14) parmi ladite pluralité d'électrodes internes (14) sont connectées à ladite paire d'électrodes externes (20, 22) respectivement.

3. Résonateur piézoélectrique (10) selon la revendication 1 ou 2, **caractérisé en ce que** plusieurs électrodes internes (14) sont partiellement exposées à des faces latérales dudit élément de base (12), et les portions exposées d'électrodes internes adjacentes (14) parmi ladite pluralité d'électrodes internes (14) sont connectées à ladite paire d'électrodes externes (20, 22), respectivement.
